(19) Europäisches Patentamt
European Patent Office
Office européen des brevets

(11) **EP 0 885 406 B1**

(12) **EUROPEAN PATENT SPECIFICATION**

(45) Date of publication and mention
of the grant of the patent:
**11.10.2000 Bulletin 2000/41**

(51) Int Cl.[7]: **G03F 7/09**

(86) International application number:
**PCT/US97/03754**

(21) Application number: **97914962.2**

(22) Date of filing: **06.03.1997**

(87) International publication number:
**WO 97/33200 (12.09.1997 Gazette 1997/39)**

(54) **LIGHT-ABSORBING ANTIREFLECTIVE LAYERS WITH IMPROVED PERFORMANCE DUE TO REFRACTIVE INDEX OPTIMIZATION**

LICHT-ABSORBIERENDE ANTIREFLEKTIONSSCHICHTEN MIT VERBESSERTER LEISTUNG DURCH BRECHUNGSINDEX-OPTIMIERUNG

COUCHES ANTIREFLET ABSORBANT LA LUMIERE POSSEDANT UNE PLUS GRANDE EFFICACITE GRACE A L'OPTIMISATION DE L'INDICE DE REFRACTION

(84) Designated Contracting States:
**DE FR GB IT**

(30) Priority: **07.03.1996 US 13007 P**

(43) Date of publication of application:
**23.12.1998 Bulletin 1998/52**

(73) Proprietor: **Clariant Finance (BVI) Limited
Road Town, Tortola (VG)**

(72) Inventors:
• **DAMMEL, Ralph, R.
Flemington, NJ 08822 (US)**
• **NORWOOD, Robert, A.
Cranford, NJ 07016 (US)**

(74) Representative: **Hütter, Klaus, Dr. et al
Clariant GmbH
Patente, Marken, Lizenzen
Am Unisys-Park 1
65843 Sulzbach (DE)**

(56) References cited:
**DE-A- 4 327 662**

• **PATENT ABSTRACTS OF JAPAN vol. 095, no. 009, 31 October 1995 & JP 07 153682 A (SONY CORP), 16 June 1995, cited in the application**
• **OPTICAL/LASER MICROLITHOGRAPHY V, SAN JOSE, CA, USA, 11-13 MARCH 1992, vol. 1674, pt.1, ISSN 0277-786X, PROCEEDINGS OF THE SPIE - THE INTERNATIONAL SOCIETY FOR OPTICAL ENGINEERING, 1992, USA, pages 147-156 vol.1, XP002034766 MIURA S S ET AL: "Reduction of linewidth variation over reflective topography"**
• **JOURNAL OF THE ELECTROCHEMICAL SOCIETY, vol. 137, no. 12, 1 December 1990, pages 3900-3905, XP000168107 TANAKA T ET AL: "A NEW PHOTOLITHOGRAPHY TECHNIQUE WITH ANTIREFLECTIVE COATING ON RESIST: ARCOR"**
• **MICROELECTRONIC ENGINEERING, vol. 25, no. 1, 1 May 1994, pages 21-34, XP000450303 ALEXANDER K E ET AL: "ON THE PROCESSING OF I-LINE POSITIVE RESISTS WITH A TOP ANTI-REFLECTIVE COATING"**

**Description**

**Background of the Invention**

One of the problems encountered in practical semiconductor device manufacture is the dependence of the imaging dose of the photoresist on the photoresist thickness. If resist films below about 4 μm (micrometers) thickness are used, as they are in the most common applications for high resolution devices, thin film interference effects lead to periodic behavior of the resist sensitivity, the "swing curve". Resist sensitivity can vary dramatically over a small change in film thickness. On a substrate with topography, this limits the accuracy to which resist features can be imaged, and it also reduces the apparent depth of focus. Moving from g-line to i-line and eventually DUV radiation brings with it a large increase of the substrate reflectivity, leading to an acerbation of the problem.

The classic solution to the above problem has been the use of dyed photoresist materials. Dyed resists add a non-bleachable absorption to the photoresist (i.e., they increase the Dill B parameter). This reduces the swing curve by causing increased attenuation of the light in the resist, even when the resist is near to full exposure where without the dye it would be quite transparent. Both swing curve and standing waves are reduced by the addition of dye.

However, use of dyed resists carries a considerable price: resists with all but the very lightest dye loadings always exhibit large increases in exposure doses as well as reduced wall angles and final resolution. Both optical and chemical reasons contribute to this deterioration; while the chemical effects (which are due to the changes in the resist development parameters caused by the dye addition) may be minimized by judicious choice of the dye's chemical structure, the optical effects (larger Dill B parameter, i.e., increased unbleachable absorption) are inherent in the concept of dye addition, and cannot be avoided. Still, the ease of use of dyed resists has in the past made them the most popular solution to reflectivity and swing curve woes.

In the last few years, organic antireflective coatings have entered the market place, and in many cases have proven to be a crucial technology enabling users to safely run processes which previously had low or no latitude. The ease of use of water-soluble antireflective topcoats, which offer only minimal increases in process complexity, has made them a logical choice for users trying to enlarge their process window.

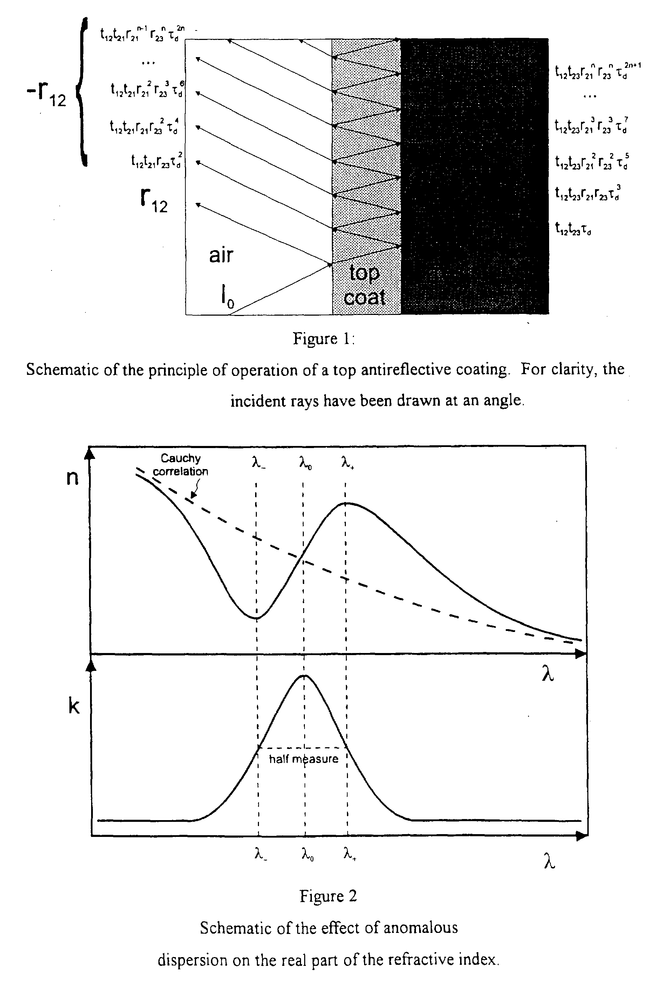

Light falling on a substrate through a thin film undergoes an infinite series of reflections at the boundaries between the thin film and the air as well as at the film/substrate boundary, as shown in Fig. 1. The incoming and outgoing waves interfere in the film, causing constructive interference if their phase difference is an even multiple of π, and destructive interference if their phase difference is an odd multiple of π. Physicists call this film stack a Fabry-Perot etalon, the theory of which is well established. From these considerations, an approximative formula can be derived (cf., e.g., T. Brunner, Proc. SPIE 1466, 297(1991)) which relates the swing curve ratio of a resist to the reflectivity $R_t$ at the resist-air interface, and the reflectivity $R_b$ at the resist/substrate interface:

$$S = 4\sqrt{R_t R_b} \cdot e^{-\alpha_r \cdot d}, \tag{1}$$

where d is the resist thickness and $\alpha_r$ is the resist absorption coefficient.

Essentially, the idea behind the top antireflective layer is to change the phase of light passed through the layer in such as way that the first and the sum of all subsequent reflection amplitudes in Fig. 1 are out-of-phase by 180 degrees. Incoming and outgoing wave amplitudes interfere destructively, and the swing curve vanishes. Manipulation of the appropriate equations gives two necessary conditions for this phase change:

1. The first and the sum of all subsequent reflection amplitudes are opposite in phase when the film thickness $t$ of the antireflective layer is an odd multiple of $t = \lambda/(4n_t)$, where $n_t$ is the real part of the refractive index of the top layer; and
2. The first and the sum of all subsequent reflection amplitudes are equal in intensity if $n_t = \sqrt{n_r}$, where $n_r$ is the refractive index of the photoresist.

It should be realized that the above equation (1) provides a simple first-order approximation to the swing curve ratio. Employing a more exact treatment, one finds that the swing curve ratio for exposure on a DNQ photoresist will not be zero even if the above conditions are exactly met. Using the Prolith/2 lithography simulator, sold by Finle Technology of Austin, Texas, one finds that for a perfect match it is possible to reduce the swing curve to about 5% of the original value (Example 3). If the simulation data are interpolated linearly, one finds that the predicted remaining swing ratio is less than 1%. In practice, the optimum situation will be somewhat worse since the photoresist changes its absorption and its refractive index during exposure, so that a top layer with an unchanging refractive index cannot be matched to both the beginning and end conditions at the same time. This effect is not taken into account by the Prolith™ simulator.

If one looks for chemical materials to make a top antireflective layer, it turns out that while the first condition, $t=\lambda/(4n_t)$, can be met fairly easily, fulfilling the second one, $n_t = \sqrt{n_r}$, meets with some fairly formidable obstacles. The refractive index of a photoresist at i-line is typically about 1.72 to 1.75, which calls for an antireflective coating with a refractive index of $n_t$ = 1.31 to 1.32. For easier measurement, the literature mostly references the refractive indices at the typical metrology wavelength of 633 nm (nanometers), making the somewhat incorrect assumption that the dispersion behavior of both materials will be identical. In this case, the refractive indices become $n_r$ = 1.64 and $n_t$ = 1.28. Unfortunately, it is difficult to find organic materials with refractive indices in the range of 1.28 to 1.31. Known examples include heavily fluorinated, teflon-like polymers which require exotic or environmentally unacceptable solvents such as chlorofluorocarbons as spincasting solvents. Moreover, early examples of these layers had to be removed in a second solvent treatment step prior to development.

The TAR concept gained practical importance only with the advent of water-based, developer-soluble antireflective coatings. These coatings, which were originally developed by researchers at IBM Corp. and which have been described in EP 522990, have a dramatically simplified mode of application. They can be spun on from water directly onto the photoresist in two different ways:

1. in a "coat-bake-coat" process in which the resist is first coated and prebaked, and the top coating is then spun on top of the dry resist; it becomes non-tacky without the need for a second bake step; or
2. in a "coat-coat-bake" process in which the top coating is spun on top of the wet resist film, and both are baked together.

For most resist materials, it is even possible to use a single spin coater, since the edge bead removal typically can be set up to clean the coater bowl of all top coat residues. For puddle or spray development, no separate step is needed to remove the top coat after exposure; it is fully developer-soluble and will be washed away in the first few seconds of the development process. For very sensitive processes or for immersion development, it is possible to remove the top coat by a short water rinse.

In order to insure water solubility of the top coat, some compromises have to be made with respect to its refractive index. Consequently, water-based topcoats do not achieve the optimum refractive index of 1.28; one commercial material, the AZ® Aquatar coating, available from AZ Photoresist Products, Somerville, New Jersey, has a refractive index of 1.41. Since over a wide range of refractive indices, the swing curve ratio is an approximately linear function of the absolute value of the difference between refractive indices, this material yields not a 100% but only a 66% reduction in the swing curve. However, for very fine feature sizes and other demanding applications, it is desirable to further reduce the swing curve below the practically achieved 66% reduction. This invention teaches that the use of absorbing top antireflective layers is an approach that makes it possible to achieve this goal with water-based antireflective coatings, and it teaches a practical way to achieve and design such systems.

Description of the Invention

In the following, we will be writing the refractive index as a complex number $N=n-ik$, where $n$ is the real part of $N$, and is equivalent to what is commonly called "the refractive index". $k$, the imaginary part of $N$, is related to the absorption coefficient as a function of wavelength, $\alpha(\lambda)$, by $k=\alpha \lambda/(4\pi)$. In the above we have followed the "optical" (vs. the "physical") convention for the sign of $k$.

Two effects combine to make the use of absorbing top antireflective layers particularly practical and advantageous: anomalous dispersion and non-reflective index intensity matching.

1. In regions of high absorbance, the real part of the refractive index shows what is known as ***anomalous dipersion.*** A schematic of anomalous dispersion is shown in Fig.
2. As can be seen, in the wavelength region below the absorbance maximum, the refractive index shows a decrease the size of which is correlated to the strength of the absorption.

The relation between the real and the imaginary part of the refractive index $k_b = \alpha \lambda/(4\pi)$ is given via the dielectic constant $\varepsilon = \varepsilon' - i \varepsilon'' = \tilde{n}^2 = n^2 - k^2 - 2i\,n\,k$ by a special Hilbert transform called a Kramers-Kronig relation:

$$\varepsilon'(\omega) - 1 = \frac{2}{\pi}\mathbf{P}\int\limits_0^\infty d\omega' \; \frac{\varepsilon''(\omega')\omega'}{\omega'^2 - \omega^2}$$

$$\varepsilon''(\omega) = -\frac{2\omega}{\pi}\mathbf{P}\int\limits_0^\infty d\omega' \; \frac{\varepsilon'(\omega') - 1}{\omega'^2 - \omega^2}$$

$$(2)$$

where $\omega = c/(2\pi\lambda)$, and where **P** denotes that the principal part of the integral is to be taken.

However, practical application of the relations (2) may be very cumbersome since in principle one has to know the absorption spectrum over the entire electromagnetic spectrum. In practice, it is usually found for reasonably symmetrical absorption bands that at the absorption maximum, the anomalous dispersion contribution is approximately zero, that the local maximum occurs just before the half height of the absorption band on the long wavelength side, and the local minimum just after the half height on the low wavelength side. These positions have been indicated as $\lambda_{max}$, $\lambda_+$ and $\lambda_-$ in Fig. 2.

By a judicious choice of the right dye, it is thus possible to select the absorption maximum and half width of the absorption band in such a way that the real part of the refractive index is strongly depressed at a target wavelength, e.g., the lithographically important mercury i- or g-line bands at 365 and 435 nm (nanometers), or the KrF and ArF excimer laser wavelengths at 248 and 193 nm (nanometers). In principle, nearly any value of the real part of the refractive index can be reached by using anomalous dispersion: it may be raised above 40 or even lowered below the value of 1 for extremely absorbing substances (e.g., for cadmium sulfide around 250 cm$^{-1}$)

In practice, for organic dyes in the region of interest (450-180 nm), it is difficult to reach absorption values above $\alpha$ = 20 $\mu$m$^{-1}$, or $k$ values above 0.6 to 0.7. If the additional constraint is added that the material must be film forming, typically only about a maximum of 60-70% of the material's mass will consist of an active dye, whether polymerically bound or in the form of an admixture of a dye to a film forming material. This means that for practical purposes, typical $\alpha$ values will be limited to a maximum of 12 to 14 $\mu$m$^{-1}$.

For example, a commercial antireflective bottom layer, AZ®BARLi™ coating, available from AZ Photoresist Products, Somerville, New Jersey, which is the film-forming organic material the most strongly absorbing in the near-UV region known to the inventors, has an absorption of $\alpha$ = 11.5 $\mu$m$^{-1}$ at 365 nm, corresponding to a $k$ value of 0.334. A measurement of the dispersion curve of this material by spectroscopic ellipsometry showed that the total change of the real part of the refractive index $n(\lambda_+)$-$n(\lambda_-)$ was about 0.32. Although AZ®BARLi™ coating is solvent-based and not water soluble, this demonstrated that a refractive index reduction of about $\Delta n$ = 0.16 can be achieved with organic film forming materials. With many organic materials available that have refractive indices of 1.45 and below, it is thus feasible to reduce the real part of the refractive index to the optimum range for maximum swing curve reduction by adding absorption to the film and utilizing anomalous dispersion. This strategy is aided by the fact that, as will be shown below, the optimum refractive index range for absorbing top coats is higher for absorbing materials than for non-absorbing materials.

3. In absorbing top antireflective layers, the match of the absolute values of the amplitudes of the first reflection and the sum of all rays being refracted out of the top layer (cf. Fig. 1) is partially provided by the **attenuation of the ray in the absorbing medium**. Some light is now lost to absorption, and the above sum must now be smaller than before in order to still meet the intensity match criterion. It follows that the optimum refractive index of an absorbing top layer must be higher than that of a non-absorbing one, and that the higher the absorption of the top layer, the higher the refractive index of the top layer must become in order to compensate. This phenomenon has been referred to above as "non-reflective intensity matching".

A Japanese patent application (Japanese Patent Office Public Disclosure Bulletin No. 7-153682, to Sony Co., dated June 16, 1995; henceforth called the "Sony application") describes a lithographic process which makes use of dyed antireflective coatings for DUV lithography applications (180-300 nm (nanometers)). The Sony application describes the effects of attenuation of the beam in the dyed layers based on modeling of the reflectivities of the antireflector/resist film stack. It does not teach the use of anomalous dispersion to reach optimal or near optimal refractive indices of the top antireflective layer.

It remains to be shown what the optimality conditions are for such a light-absorbing top antireflective layer. For absorbing media, the formulae from which optimality conditions such as the ones given in Section 1.2 for non-absorbing top layers can be derived can become rather complex. It is therefore easier to use a numerical simulator such as Prolith/2 to calculate the optimum film properties (thickness, absorption, refractive index) for maximum swing curve reduction. Example 4 provides such an analysis.

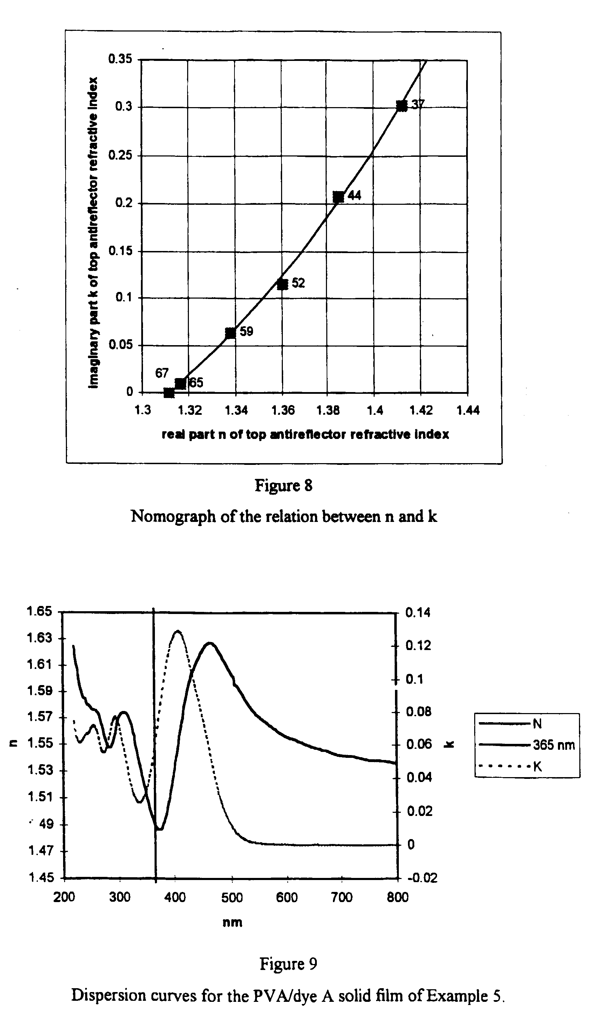

As can be seen from Example 4, the optimum refractive index indeed increases with the absorption of the top antireflective layer, as predicted above on the basis of qualitative arguments. Table 3 and Figure 8 provide quantitative insight into the relationship between real and imaginary parts of the refractive index and the toplayer thickness.

## Practical Implementation Of Light-Absorbing Antireflective Top Layers

The use of dyed toplayers which utilize anomalous dispersion to achieve an improved match between the resist and top antireflector optical properties is not limited to any particular casting solvent. While water is preferred as a casting solvent due to ease of use and environmental friendliness, it is also possible to utilize solvent-based antireflective topcoats. The solvent for these materials may then either be chosen in such a way that no intermixing occurs with the photoresist, or one may counteract intermixing problems by a transparent barrier layer, preferably of thickness $\lambda/(2n)$, which makes the layer optically neutral. Typically, such a solvent-cast antireflective top layer would be removed in a solvent rinse step prior to development. To reduce the process complexity involved with this, one might consider to design the top layer in such a way that it is spincast from a solvent, but soluble in the developer.

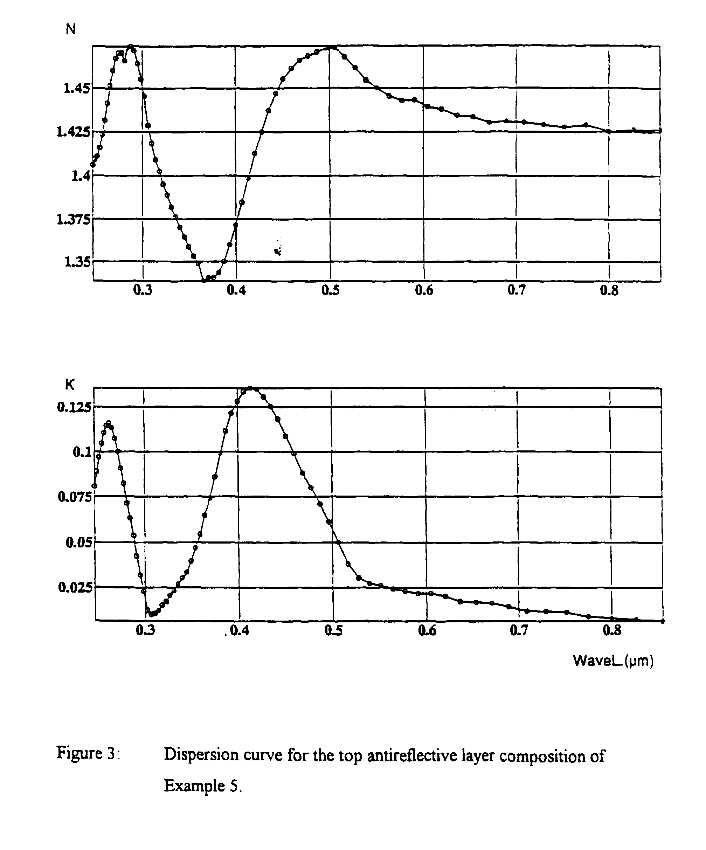

For the purposes of optics, a top antireflector film is completely characterized by its complex index of refraction and thickness (provided that the film is homogeneous). It follows that the chemical vehicle by which the absorption is introduced into the antireflective layer is of no consequence: whether a dye is introduced as a polymeric material which is in itself film-forming, or whether the absorption is caused by a monomeric dye added to a polymeric film former, the swing curve reducing action is the same if the optical constants are the same. Example 1 describes a top antireflective layer consisting of an aqueous solution of a polyacrylic acid film former, a perfluorinated surfactant of low refractive index, and a water-soluble dye (FD&C Yellow #5). The relative ratios of the components have been chosen so as to form a film with $\alpha = 4 \ \mu m^{-1}$. The dispersion curve of the film as obtained by spectroscopic ellipsometry (Fig. 3) shows that for i-line exposure, the film's refractive index has been closely matched to the optimum value by the use of the anomalous dispersion effect. The value of $n = 1.339$ at 366 nm (nanometers) is actually lower than the optimum value found in Example 3 as the optimum refractive index for a top antireflector of that absorbance. An optimum match can be achieved by lowering the amount of dye added to the solution.

While Example 1 shows that anomalous dispersion efects may be utiized to achieve optimum optical constants. Example 3 demonstrates the beneficial effects of dyed top antireflectors. The methods used are tested and validated in Example 2 against the well-known case of a transparent top antireflector. Finally, Example 4 defines the optimality conditions for dyed top antireflectors as sets of $\{n, k, t\}$ values.

## Summary Of The Invention

The invention teaches a light absorbing top antireflective layer which reduces the swing curve amplitude for photoresist materials used in the semiconductor industry, and of processes for its use. The light absorbing top antireflective layer is characterized by the fact that the shape of its dispersion curve is as depicted in Figure 2, which is equivalent to saying that it has a negative slope at some point in a lithographically useful wavelength range. The coating may be water based but is not necessarily so. The advantage of a water-based coating is its ease of use, since it can be applied without intermixing to the softbaked photoresist, and is removed in the development step, so that process complexity is only minimally increased.

One problem that has been associated with the existing non-absorbing antireflective coatings is that the optimum swing curve reduction is only achieved at a very low refractive index of the top coat. The invention teaches a dyed coating as a way to modify (typically lower) the refractive index of an anitireflective layer by means of anomalous dispersion into a range in which it shows improved performance as a top antireflective layer. The advantages of a dyed coating are a) that the refractive index of the top coat can be lowered by making use of anomalous dispersion effects if the dye is chosen judiciously, and b) that it is possible to achieve the optimum swing curve reduction at a higher refractive index of the top coat. By a combination of these two effects, the present invention demonstrates a reduction of the swing curve close to the theoretical minimum value, which constitutes a substantial improvement over existing antireflective topcoats.

The following specific examples will provide a detailed illustration of using the present invention. These examples are not intended, however, to limit or restrict the scope of the invention in any way and should not be construed as providing conditions, parameters or values which must be utilized exclusively in order to practice the present invention.

## Example 1: Use of anomalous dispersion to lower the refractive index of a top antireflective layer

The commercial antireflective AZ® Aquatar coating was mixed with a commercial solution of a yellow dye in a weight ratio of 2.5 to 1.5. The dye used was McCormick Food Yellow, the major active component of which is FD&C Yellow No. 5, also known as tartrazine. McCormick Food Yellow contains a small part of Allura Red food dye as well as non-dyed ingredients such as ethylene glycol. The resulting mixture was spun on a silicon wafer to yield an approx. 300 nm (nanometers) coating. After storage overnight, the real and imaginary part of the refractive index as well as the thickness were determined by spectroscopic ellipsometry on a SOPRA ES4G spectroscopic ellipsometer. The thickness was first determined by fitting a Cauchy model to the long wavelength part of the dispersion curve, where $k$ was known to be zero from UV spectroscopic measurements. With the known thickness, the dispersion curves for $n$ and $k$ were then measured for the entire spectral range from 700 to 220 nm (nanometers) (Figure 3). It was found that the dispersion curve for $n$ shows the kind of dip depicted in Figure 2, and that the minimum occurs at a wavelength of 366 nm (nanometers) with a value of $n$=1.339. The maximum in the $k$ dispersion curve occurred at 412 nm (nanometers) with a value of $k$=0.136. The refractive index of the AZ® Aquatar coating at this wavelength was determined by mode coupling experiments to be approx. 1.42. The refractive index has thus been lowered by a value of 0.08 by the addition of the dye.

Example 2: Prolith/2 calculations of the swing curve ratio for a non-absorbing top antireflector ($\alpha$=0 $\mu$m$^{-1}$) (Comparative Example)

The swing curve reduction for a non-dyed antireflector in -line exposure was calculated by the PROLITH/2 lithography simulator program. The AZ7500, available from AZ Photoresist Products, Somerville, New Jersey, parameter set contained in the program (Version 4.05) was used with the change that the resist refractive index was set to 1.7161 for 365 nm (nanometers). The antireflector was made non-absorbing by setting its A and B parameters to zero. Swing curves (open point dose vs. resist thickness) were calculated for antireflector film thicknesses between 0.040 and 0.080 $\mu$m (micrometers) using the program's nested multiple run feature. The data were saved in ASCII files and imported into the Microsoft Excel spreadsheet program. Using a nonlinear least squares fit through the program's SOLVER function, swing curves were fitted to the equation

$$E = a \cdot Cos(\frac{4\pi}{\lambda} n_r t + c) + d * t + e,$$

where $a,c,d$ and $e$ are the fit parameters, and $t$ is the resist film thickness. The fit was carried out without constraints but the swing amplitude was always assured to be positive by choice of appropriate phase parameters $c$ as starting conditions. The obtained "$a$" parameters were then divided by the "$a$" parameter of the swing curve of the resist without a top antireflector. The results of this analysis are listed in Table I.

<u>Table 1: Relative swing curve ratios (vs. the resist without top antireflector layer) as a function of the top antireflector's film thickness and refractive index for a non-absorbing top layer. All numbers in %. For details of calculation see text.</u>

| t [μm] | refract. index 1.26 | 1.28 | 1.3 | 1.31 | 1.32 | 1.34 | 1.36 | 1.38 | 1.4 | 1.41 | 1.42 |
|---|---|---|---|---|---|---|---|---|---|---|---|
| 0.04 | 61.65 | 59.78 | 57.95 | 57.79 | 56.83 | 55.99 | 55.15 | 55.63 | 55 | 55.2 | 55.48 |
| 0.045 | 53.16 | 50.6 | 49.17 | 48.16 | 47.39 | 46.61 | 46 | 45.87 | 46.49 | 46.91 | 47.66 |
| 0.05 | 43.99 | 41.69 | 39.24 | 38.32 | 37.71 | 36.41 | 36.61 | 36.76 | 38.09 | 38.25 | 39.57 |
| 0.055 | 34.73 | 32.02 | 29.01 | 28.08 | 27.31 | 26.87 | 27.01 | 28.21 | 30.14 | 31.49 | 33.46 |
| 0.06 | 26.06 | 22.27 | 18.63 | 18.11 | 16.88 | 16.88 | 18.59 | 21.26 | 24.54 | 26.4 | 29.08 |
| 0.065 | 17.99 | 13.23 | 8.6 | 7.65 | 7.04 | 9.08 | 13.32 | 18.81 | 23.9 | 26.65 | 29.13 |
| 0.07 | 13.51 | 7.86 | 2.73 | 3.52 | 5.66 | 10.99 | 16.61 | 21.99 | 28.05 | 30.29 | 32.96 |
| 0.075 | 15.68 | 12.89 | 13.45 | 14.46 | 16.16 | 20.34 | 25.18 | 29.85 | 35.19 | 38.01 | 40.6 |
| 0.08 | 22.73 | 22.22 | 23.95 | 25.41 | 26.84 | 30.35 | 34.93 | 39.3 | 43.97 | 46.26 | 48.84 |

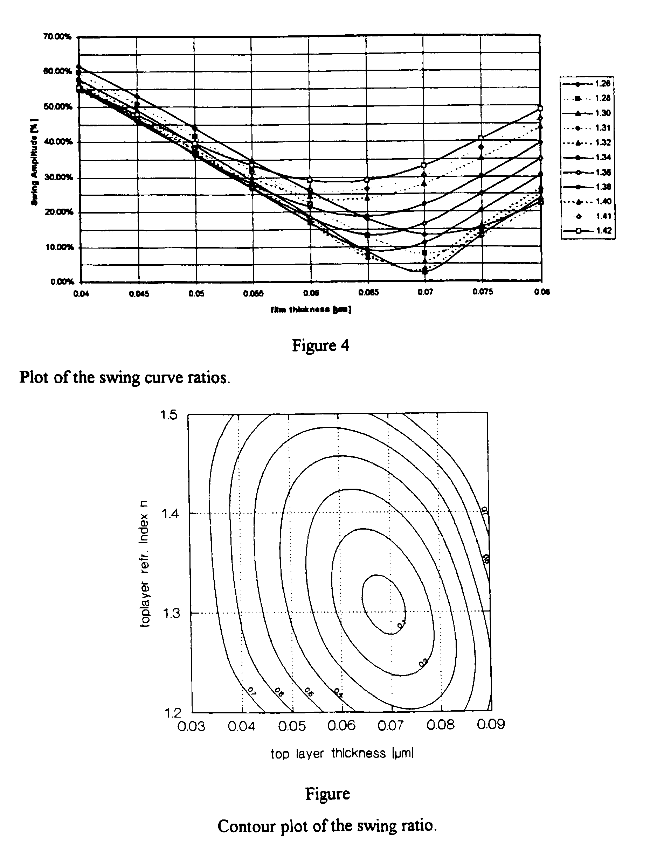

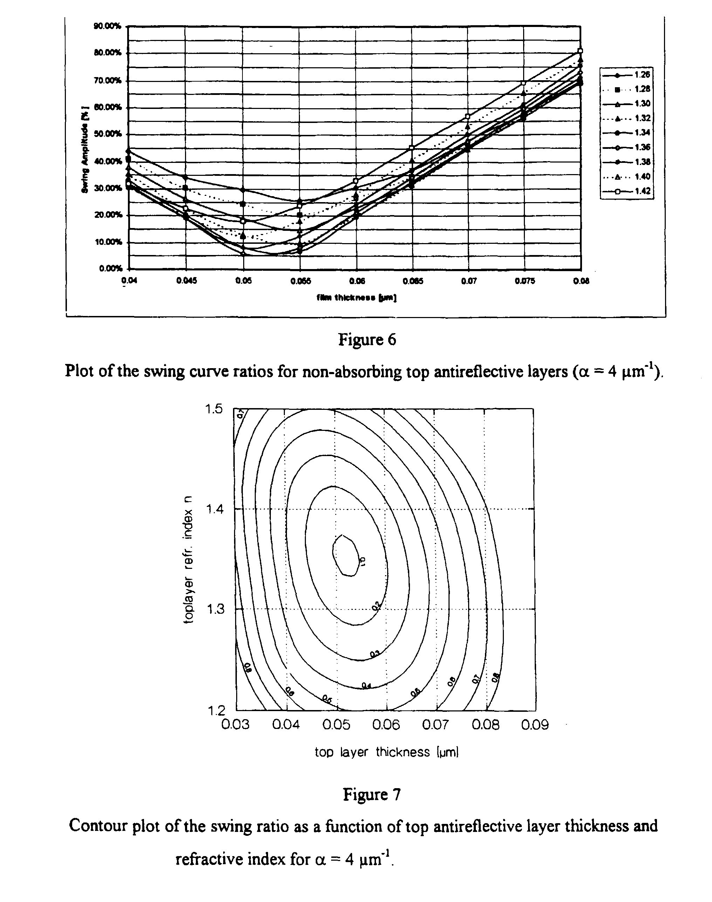

It is seen that the minimum of the swing curve ratio is obtained for a refractive index between 1.30 and 1.31 at a film thickness of 0.07 μm (micrometers), in good accordance with the prediction of the antireflector model described in the Background section. A linear extrapolation of the two branches of the swing curve vs. antireflector film thickness plot (cf. Figure 4) yields an intersection point of 0.6% at a film thickness of 0.0687 μm (micrometers). A contour plot of the swing ratio as a function of TAR thickenss and refractive index for the case $\alpha = 0$ is provided in Figure 5.

By comparison, at the refractive index of the AZ® Aquatar coating (n=1.42 at 365 nm), one observes a swing curve ratio of 29% for an optimum film thickness of approximately 0.063 μm (micrometers).

Example 3: Prolith/2 calculations of the swing curve ratio for a dyed top antireflector with absorptivity $\alpha$=4 μm$^{-1}$

The calculations of Example 2 were repeated with the difference that the B parameter of the top antireflective layer was set to a value of 4.0 μm$^{-1}$ in order to make the top layer absorbing. This B parameter corresponds to a *k* value of 0.116. The results are tabulated in Table 2 below.

It is seen by inspection of Table 2 that the minimum has moved to a higher refractive index and is now found between n=1.36. At the same time, the optimum top layer thickness has decreased to between 0.050 and 0.055 μm (micrometers). A linear extrapolation of the two branches of the swing curve vs. antireflector film thickness plot (cf. Figure 6) yields an intersection point of 0.7% at a film thickness of 0.0520 μm (micrometers). A contour plot of the swing ratio as a function of TAR thickness and refractive index for the case $\alpha$ - 4 is provided in Figure 7.

### Table 2: Relative Swing Curve Ratios (Vs. The Resist Without Top Antireflector Layer) As A Function Of The Top Antireflector's Film Thickness And Refractive Index For A Top Layer With K=0.116. All Numbers In %. For Details Of Calculation See Text.

| d [µm] | refract. index 1.26 | 1.28 | 1.30 | 1.32 | 1.34 | 1.36 | 1.38 | 1.40 | 1.42 |
|---|---|---|---|---|---|---|---|---|---|
| 0.04 | 43.89 | 40.90 | 37.92 | 35.26 | 33.14 | 31.51 | 30.71 | 30.73 | 31.82 |
| 0.045 | 34.31 | 30.31 | 26.31 | 22.74 | 20.29 | 19.00 | 18.91 | 20.21 | 22.73 |
| 0.05 | 29.67 | 24.26 | 18.84 | 13.10 | 8.25 | 5.87 | 8.23 | 12.58 | 17.91 |
| 0.055 | 25.78 | 20.28 | 14.77 | 9.82 | 6.85 | 8.31 | 12.42 | 18.03 | 23.65 |
| 0.06 | 30.66 | 26.72 | 22.78 | 20.20 | 19.44 | 21.09 | 24.27 | 28.19 | 32.99 |
| 0.065 | 36.86 | 34.48 | 32.11 | 31.41 | 32.47 | 34.36 | 37.04 | 40.67 | 45.23 |
| 0.07 | 47.92 | 46.33 | 44.73 | 44.69 | 45.53 | 47.41 | 50.08 | 53.15 | 56.98 |
| 0.075 | 57.73 | 56.98 | 56.22 | 56.39 | 58.00 | 59.73 | 61.26 | 65.50 | 68.99 |
| 0.08 | 69.62 | 69.34 | 69.06 | 69.74 | 71.10 | 73.04 | 75.50 | 77.76 | 80.99 |

These results indicate that the swing curve reduction by a optimal dyed top antireflector is comparable to that of an optimal non-dyed one. The optimal dyed antireflector offers the additional advantage that the optimum operating point is located at a higher refractive index. It offers the disadvantage that the required dose is increased: relative to the undyed top antireflector, as a result of loss of light by absorption in the top latyer. If the required dose-to-clear for the first swing curve max. after 0.8 µm (micrometers) for AZ®7500 resist with no top antireflector = is set as 100%, the dose-to-clear with the undyed top layer is calculated to about 70%, and that of the dyed antireflector with a=4µm$^{-1}$ is calculated to be 97%, where both of the latter are for the optimal optical properties of the top antireflectors determined in Examples 2 and 3.

Example 4: Relationship between $n$, $k$ and $t$ for optimum swing curve reduction

Using the techniques described in Example 2 and 3, a series of calculations were carried out for various values of the toplayer refractive index components $n_T$ and $k_T$ as well as the the top antireflector film thickness $t$ in order to determine the relation between them. Using a sample of 7 points, it was found that near-zero swing curve ratios could be obtained if $n_T$ and $t$ as well as $k_T$ and $t$ were related by the regressions

$$t = -0.3034\, n_T + 0.4647,\ r^2 = 0.9993$$

$$t = 0.0666\, exp(-1.973\, k_T),\ r^2 = 0.9984,$$

which when combined yield the relation

$$n_T = 1.5316 - 0.2195\, exp(-2\, k_T),$$

where the exponent 1.973 has been replaced with 2. Figure 8 shows the excellent quality of this fit of $n_T$ vs. $k_T$ in a nomograph (data see Table 3).

Table 3:

| Optimum Refractive Index, Film Thickness, For Various Toplayer Absorptivities. Results are for Prolith/2 calculations at 365 nm exposure wavelength[1]. | | | | | |
|---|---|---|---|---|---|
| $\alpha$ [$\mu$m$^{-1}$] | k | n | t [$\mu$m] (from k) | t [$\mu$m] (from n) | t average[2] [$\mu$m] |
| 0 | 0.000 | 1.320 | 0.067 | 0.064 | 0.065 |
| 2 | 0.058 | 1.352 | 0.059 | 0.054 | 0.057 |
| 4 | 0.116 | 1.372 | 0.053 | 0.048 | 0.051 |
| 6 | 0.174 | 1.389 | 0.047 | 0.043 | 0.045 |
| 8 | 0.232 | 1.405 | 0.042 | 0.038 | 0.040 |
| 10 | 0.290 | 1.419 | 0.037 | 0.034 | 0.036 |
| 12 | 0.349 | 1.431 | 0.033 | 0.030 | 0.032 |

1. see Example 3 for simulation parameters

2. av. value may deviate from average of tabulated values since more digits are used for calculation.

Example 5: Practical Verification of Theoretical Prediction

A solution of a dye product obtained from Milliken Chemical, Spartanburg, South Carolina (DYE A, 90 parts w/w) was prepared with a 10 parts w/w of a polyvinyl alcohol binder, MW ca. 8-9,000, as an aqueous solution to yield a film of 520 Å thickness with optical constants at 365 nm of n = 1.4905 and k=0.05595, corresponding to an absorption of $\alpha$ = 1.926 $\mu$m$^{-1}$, as determined by spectroscopic ellipsometry using a J.A. Woollam, Inc. variable angle spectroscopic ellipsometer. The position of the minimum is nearly perfectly matched with the 365 nm (nanometers) exposure wavelength (cf. Figure 9) but the absorptivity of the dye is not sufficient to quite come into the optimum range as defined by Example 4. This formulation is therefore not expected to fully suppress the swing curve.

For a film with the thickness and optical constants given above, the Prolith™ lithography simulator predicts a reduction of the dose-to-clear swing ratio of AZ®7800 resist, a commercial product of AZ Photoresist Products, Somerville, NJ, to about 46% of the value observed in the absence of the antireflector film. An experimental dose-to-clear swing curve obtained on a Nikon i-line stepper (development in 2.38% TMAH solution) showed a reduction of the swing amplitude to 55% (from $\pm$18 mJ/cm$^2$ to $\pm$10mJ/cm$^2$). The difference maybe due to low coating uniformity of the antireflector film which may be a consequence of the very high dye concentration.

**Claims**

1. A top antireflective coating for a photoresist, comprising an absorbing film wherein, anomalous dispersion caused by light absorption from irradiation wavelength brings real and imaginary part of refractive index of the top antireflective coating closer to conditions for which reflectivity of film stack into air is minimized.

2. The top antireflective coating of Claim 1, wherein intensity and position of absorption is chosen such as to cause a reduction in the real part of the refractive index of the antireflective coating at the irradiation wavelength .

3. The top antireflective coating of Claim 1, wherein the absorption causing the anomalous dispersion and the real part of the refractive index is related by $n_T$ = a - b $exp$(-c $k_T$), where $n_T$ is the real part of the refractive index, $k_T$ is the imaginary part of the refractive index, a = 1.53 $\pm$ 0.153, b = 0.21 $\pm$ 0.021, and c = 2 $\pm$ 0.1.

4. The top antireflective coating of Claim 1, wherein the irradiation wavelength is in the range of 150nm to 550nm.

5. The top antireflective coating of Claim 1, which is castable from water.

6. The top antireflective coating of Claim 1, which is soluble in water.

7. The top antireflective coating of Claim 1, which is soluble in an aqueous alkaline solution.

8.  The top antireflective coating of Claim 1, comprising a monomeric dye and a polymer or mixture of polymers.

9.  The top antireflective coating of Claim 1, comprising a monomeric dye and an absorbing polymer.

10. The top antireflective coating of Claim 1, comprising an absorbing polymer.

11. The top antireflective coating of Claims 8-10, further comprising nonabsorbing additives.

12. A process for forming an image comprising:

    a) forming a photoresist film on a substrate;
    b) forming an antireflective coating comprising an absorbing film on top of the photoresist film, wherein anomalous dispersion caused by light absorption from irradiation wavelength brings real and imaginary part of refractive index of the antireflective coating closer to conditions for which reflectivity of film stack into air is minimized;
    c) imagewise exposing the photoresist film coated with the absorbing film;
    d) developing to form an image;
    e) optionally baking the substrate before or after the developing step.

13. The process of Claim 12, wherein intensity and position of absorption is chosen such as to cause a reduction in the real part of the refractive index of the antireflective coating at the irradiation wavelength.

14. The process of Claim 12, wherein the absorption of the antireflective coating causing the anomalous dispersion and the real part of the refractive index is related by an equation $n_T = a - b\,exp(-c\,k_T)$, where $n_T$ is the real part of the refractive index, $k_T$ is the imaginary part of the refractive index, $a = 1.53 \pm 0.153$, $b = 0.21 \pm 0.021$, and $c = 2 \pm 0.1$.

15. The process of Claim 12, wherein the irradiation wavelength is in the range of 150 nm to 550 nm.

16. The process of Claim 12, wherein the antireflective coating is castable from water.

17. The process of Claim 12, wherein the antireflective coating is soluble in water.

18. The process of Claim 12, wherein the antireflective coating is soluble in an aqueous alkaline solution.

19. The process of Claim 12, wherein the antireflective coating comprises a monomeric dye and a polymer or mixture of polymers.

20. The process of Claim 12, wherein the antireflective coating comprises a monomeric dye and an absorbing polymer.

21. The process of Claim 12, wherein the antireflective coating comprises an absorbing polymer.

22. The process of Claim 19-21, wherein the antireflective coating further comprises nonabsorbing additives.

23. The process of Claim 12, wherein the antireflective coating is removed during the developing step.

24. The process of Claim 12, wherein the top antireflective coating is removed by a water rinse prior to a post exposure bake treatment.

25. The process of Claim 12, wherein the top antireflective coating is separated from the photoresist by one or more barrier layers.

26. The process of Claim 25, wherein the barrier layers are transparent and are refractive index-matched to the photoresist.

27. The process of Claim 25, wherein the barrier layers are of a thickness that makes the barrier layers optically neutral.

28. The process of Claim 25, wherein the antireflective layer is removed from the barrier layer by a solvent rinse.

**Patentansprüche**

1.  Reflexionsvermindernde Deckschicht für ein Photoresist, bestehend aus einem lichtabsorbierenden Film, wobei der Real- und der Imaginärteil des Brechungsindex der reflexionsvermindernden Deckschicht infolge einer durch Lichtabsorption aus der Bestrahlungswellenlänge hervorgerufenen anormalen Dispersion Bedingungen angenähert wird, unter denen das Reflexionsvermögen der übereinandergelagerten Schichten an der Grenze zur Luft auf ein Mindestmaß eingeschränkt wird.

2.  Reflexionsvermindernde Deckschicht gemäß Anspruch 1, wobei Intensität und Lage der Absorption so gewählt werden, daß der Realteil des Brechungsindex der reflexionsvermindernden Schicht an der Bestrahlungswellenlänge reduziert wird.

3.  Reflexionsvermindernde Deckschicht gemäß Anspruch 1, wobei der Zusammenhang zwischen der eine anormale Dispersion hervorrufenden Absorption und dem Realteil des Brechungsindex durch die Formel $n_r$ = a - b $exp$(-c $k_r$) gekennzeichnet ist, wobei $n_r$ der Realteil des Brechungsindex, $k_r$ der Imaginärteil des Brechungsindex ist, a = 1,53 $\pm$ 0,153, b = 0,21 $\pm$ 0.021 und c = 2 $\pm$ 0,1.

4.  Reflexionsvermindernde Deckschicht gemäß Anspruch 1, wobei die Bestrahlungswellenlänge im Bereich von 150 nm bis 550 nm liegt.

5.  Reflexionsvermindernde Deckschicht gemäß Anspruch 1, die aus Wasser gegossen werden kann.

6.  Reflexionsvermindernde Deckschicht gemäß Anspruch 1, die in Wasser löslich ist.

7.  Reflexionsvermindernde Deckschicht gemäß Anspruch 1, die in einer wäßrig-alkalischen Lösung löslich ist.

8.  Reflexionsvermindernde Deckschicht gemäß Anspruch 1, die einen Monomerfarbstoff und ein Polymer oder ein Gemisch aus Polymeren enthält.

9.  Reflexionsvermindernde Deckschicht gemäß Anspruch 1, die einen Monomerfarbstoff und ein absorbierendes Polymer enthält.

10. Reflexionsvermindernde Deckschicht gemäß Anspruch 1, die ein absorbierendes Polymer enthält.

11. Reflexionsvermindernde Deckschicht gemäß Anspruch 8 - 10, die ferner nicht absorbierende Zusätze enthält.

12. Verfahren zur Herstellung einer Abbildung, das aus folgenden Schritten besteht:

    (a) Herstellung eines Photoresistfilms auf einem Träger;

    (b) Herstellung einer reflexionsvermindernden Schicht aus einem absorbierenden Film auf dem Photoresistfilm, wobei der Real- und der Imaginärteil des Brechungsindex der reflexionsvermindernden Schicht infolge einer durch Lichtabsorption aus der Bestrahlungswellenlänge hervorgerufenen anormalen Dispersion Bedingungen angenähert wird, unter denen das Reflexionsvermögen der übereinandergelagerten Schichten an der Grenze zur Luft auf ein Mindestmaß eingeschränkt wird;

    (c) abbildungsgemäße Belichtung des mit dem absorbierenden Film überschichteten Photoresistfilms;

    (d) Entwicklung zur Herstellung einer Abbildung;

    (e) wahlweise Trocknen des Trägers vor oder nach der Entwicklung.

13. Verfahren gemäß Anspruch 12, wobei Intensität und Lage der Absorption so gewählt werden, daß der Realteil des Brechungsindex der reflexionsvermindernden Schicht an der Bestrahlungswellenlänge reduziert wird.

14. Verfahren gemäß Anspruch 12, wobei der Zusammenhang zwischen der eine anormale Dispersion hervorrufenden Absorption der reflexionsvermindernden Schicht und dem Realteil des Brechungsindex durch die Formel $n_r$ = a - b $exp$(-c $k_r$) gekennzeichnet ist, wobei $n_r$ der Realteil des Brechungsindex, $k_r$ der Imaginärteil des Brechungsindex

**EP 0 885 406 B1**

ist, a = 1,53 ± 0,153, b = 0,21 ± 0,021 und c = 2 ± 0,1.

**15.** Verfahren gemäß Anspruch 12, wobei die Bestrahlungswellenlänge im Bereich von 150 nm bis 550 nm liegt.

**16.** Verfahren gemäß Anspruch 12, wobei die reflexionsvermindernde Schicht aus Wasser gegossen werden kann.

**17.** Verfahren gemäß Anspruch 12, wobei die reflexionsvermindernde Schicht in Wasser löslich ist.

**18.** Verfahren gemäß Anspruch 12, wobei die reflexionsvermindernde Schicht in einer wäßrig-alkalischen Lösung löslich ist.

**19.** Verfahren gemäß Anspruch 12, wobei die reflexionsvermindernde Schicht einen Monomerfarbstoff und ein Polymer oder ein Gemisch aus Polymeren enthält.

**20.** Verfahren gemäß Anspruch 12, wobei die reflexionsvermindernde Schicht einen Monomerfarbstoff und ein absorbierendes Polymer enthält.

**21.** Verfahren gemäß Anspruch 12, wobei die reflexionsvermindernde Schicht ein absorbierendes Polymer enthält.

**22.** Verfahren gemäß Anspruch 19 - 21, wobei die reflexionsvermindernde Schicht ferner nicht absorbierende Zusätze enthält.

**23.** Verfahren gemäß Anspruch 12, wobei die reflexionsvermindernde Schicht bei der Entwicklung entfernt wird.

**24.** Verfahren gemäß Anspruch 12, wobei die reflexionsvermindernde Deckschicht vor der nach dem Entwickeln durchgeführten Trocknung mit Wasser weggespült wird.

**25.** Verfahren gemäß Anspruch 12, wobei die reflexionsvermindernde Deckschicht vom Photoresist durch eine oder mehrere Sperrschichten getrennt ist.

**26.** Verfahren gemäß Anspruch 25, wobei die Sperrschichten transparent und hinsichtlich des Brechungsindex an das Photoresist angepaßt sind.

**27.** Verfahren gemäß Anspruch 25, wobei die Dicke der Sperrschichten so gewählt ist, daß sie optisch neutral sind.

**28.** Verfahren gemäß Anspruch 25, wobei die reflexionsvermindernde Schicht von der Sperrschicht durch Waschen mit dem Lösungsmittel entfernt wird.

**Revendications**

**1.** Couche anti-reflet supérieure pour un photorésist comprenant un film absorbant, dans laquelle une dispersion anormale provoquée par l'absorption de lumière provenant d'une longueur d'onde d'un rayonnement amène la partie réelle et imaginaire de l'indice de réfraction de la couche anti-reflet supérieure plus proche des conditions pour lesquelles la réflectivité de l'empilement de films dans l'air est minimisée.

**2.** Couche anti-reflet supérieure selon la revendication 1, dans laquelle l'intensité et la position d'absorption sont choisies de façon à provoquer une réduction dans la partie réelle de l'indice de réfraction de la couche anti-reflet à la longueur d'onde du rayonnement.

**3.** Couche anti-reflet supérieure selon la revendication 1, dans laquelle l'absorption provoquant la dispersion anormale et la partie réelle de l'indice de réfraction sont liées par l'équation $n_T$ = a - b $exp$(-c $k_T$), où $n_T$ est la partie réelle de l'indice de réfraction, $k_T$ est la partie imaginaire de l'indice de réfraction, a=1,53±0,153, b=0,21±0,021 et c=2±0,1.

**4.** Couche anti-reflet supérieure selon la revendication 1, dans laquelle la longueur d'onde du rayonnement est dans la gamme de 150 nm à 550 nm.

12

**5.** Couche anti-reflet supérieure selon la revendication 1, qui peut être coulée à partir d'eau.

**6.** Couche anti-reflet supérieure selon la revendication 1, qui est hydrosoluble.

**7.** Couche anti-reflet supérieure selon la revendication 1, qui est soluble dans une solution aqueuse basique.

**8.** Couche anti-reflet supérieure selon la revendication 1, comprenant un colorant monomère et un polymère ou mélange de polymères.

**9.** Couche anti-reflet supérieure selon la revendication 1, comprenant un colorant monomère et un polymère absorbant.

**10.** Couche anti-reflet supérieure selon la revendication 1, comprenant un polymère absorbant.

**11.** Couche anti-reflet supérieure selon les revendications 8 à 10, comprenant de plus des additifs non absorbants.

**12.** Procédé pour former une image consistant:

a) à former un film photorésist sur un substrat;
b) à former une couche anti-reflet comprenant un film absorbant sur le dessus du film photorésist, dans lequel la dispersion anormale provoquée par l'absorption de lumière d'une longueur d'onde d'un rayonnement amène la partie réelle et imaginaire de l'indice de réfraction de la couche anti-reflet plus près des conditions pour lesquelles la réflectivité de l'empilement de films dans l'air est minimisée;
c) à exposer selon une image le film photorésist revêtu du film absorbant;
d) à développer pour former une image;
e) à cuire éventuellement le substrat avant ou après l'étape de développement.

**13.** Procédé selon la revendication 12, dans lequel l'intensité et la position d'absorption sont choisies de façon à provoquer une réduction dans la partie réelle de l'indice de réfraction de la couche anti-reflet à la longueur d'onde du rayonnement.

**14.** Procédé selon la revendication 12, dans lequel l'absorption de la couche anti-reflet provoquant la dispersion anormale et la partie réelle de l'indice de réfraction est sous forme d'équation $n_T = a - b\ exp(-c\ k_T)$, où $n_T$ est la partie réelle de l'indice de réfraction, $k_T$ est la partie imaginaire de l'indice de réfraction, a=1,53±0,153, b=0,21±0,021 et c=2±0,1.

**15.** Procédé selon la revendication 12, dans lequel la longueur d'onde du rayonnement est dans la gamme de 150 nm à 550 nm.

**16.** Procédé selon la revendication 12, dans lequel la couche anti-reflet peut être coulée à partir d'eau.

**17.** Procédé selon la revendication 12, dans lequel la couche anti-reflet est hydrosoluble.

**18.** Procédé selon la revendication 12, dans lequel la couche anti-reflet est soluble dans une solution aqueuse basique.

**19.** Procédé selon la revendication 12, dans lequel la couche anti-reflet comprend un colorant monomère et un polymère ou un mélange de polymères.

**20.** Procédé selon la revendication 12, dans lequel la couche anti-reflet supérieure comprend un colorant monomère et un polymère absorbant.

**21.** Procédé selon la revendication 12, dans lequel la couche anti-reflet supérieure comprend un polymère absorbant.

**22.** Procédé selon les revendications 19 à 21, dans lequel la couche anti-reflet supérieure comprend de plus des additifs non absorbants.

**23.** Procédé selon la revendication 12, dans lequel la couche anti-reflet supérieure est éliminée pendant l'étape de développement.

**24.** Procédé selon la revendication 12, dans lequel la couche anti-reflet supérieure est éliminée par un rinçage à l'eau avant un traitement de cuisson après exposition.

**25.** Procédé selon la revendication 12, dans lequel la couche anti-reflet supérieure est séparée du photorésist par une ou plusieurs couches barrières.

**26.** Procédé selon la revendication 25, dans lequel les couches barrières sont transparentes et sont adaptées en indice de réfraction au photorésist.

**27.** Procédé selon la revendication 25, dans lequel les couches barrières sont d'une épaisseur qui rend les couches barrières optiquement neutres.

**28.** Procédé selon la revendication 25, dans lequel la couche anti-reflet est éliminée de la couche barrière par un rinçage au solvant.

Figure 1:

Schematic of the principle of operation of a top antireflective coating. For clarity, the incident rays have been drawn at an angle.

Figure 2

Schematic of the effect of anomalous dispersion on the real part of the refractive index.

Figure 3:     Dispersion curve for the top antireflective layer composition of

Example 5.

Figure 4

Plot of the swing curve ratios.

Figure

Contour plot of the swing ratio.

Figure 6

Plot of the swing curve ratios for non-absorbing top antireflective layers ($\alpha = 4\ \mu m^{-1}$).

Figure 7

Contour plot of the swing ratio as a function of top antireflective layer thickness and refractive index for $\alpha = 4\ \mu m^{-1}$.

Figure 8

Nomograph of the relation between n and k

Figure 9

Dispersion curves for the PVA/dye A solid film of Example 5.